# EUROPEAN PATENT SPECIFICATION

(11) **EP 1 661 256 B1**
(45) Date of publication and mention of the grant of the patent: **05.09.2007**
(21) Application number: 04768049.1
(22) Date of filing: 12.08.2004
(51) Int. Cl.: H04B 1/38, G06K 7/00

(54) **HOLDER FOR ELECTRONIC MODULE AND METHOD THEREFOR**
HALTER FÜR EIN ELEKTRONISCHES MODUL UND VERFAHREN DAFÜR
SUPPORT POUR MODULE ET SON PROCEDE

(30) Priority: 22.08.2003 GB 0319769
(43) Date of publication of application: 31.05.2006
(73) Proprietor: IPWireless, Inc., San Bruno, CA 94066 (US)
(72) Inventor: TEMPLE-BROWN, Adrian Richard Estcourt, Knowle, Pewsey, Wiltshire SN9 5JH (GB)
(74) Representative: Wray, Antony John
(86) International application number: PCT/GB2004/003482
(87) International publication number: WO 2005/020451

(56) References cited:
- EP-A- 0 947 944
- DE-A- 10 003 068
- US-A- 5 823 828

## Description

### Field of the Invention

This invention relates to modules and their incorporation and related testing capabilities in electronic equipment. The invention is applicable particularly, though not exclusively, to electronic modules such as SIM (Subscriber Identity Module) or USIM (Universal SIM) cards in communication equipment.

### Background of the Invention

In the field of this invention it is known in an ideal manufacturing environment, a high volume product is manufactured from all of its component parts into its final enclosure, boxed and shipped. Due to practical yield issues, testing is required at some stage to ensure that only operational product is boxed and shipped to the end user.

Ideally, testing is performed using only the interfaces that are physically available on the final finished product, denying test interface access to the user, maintaining product aesthetics, minimising overall cost and complexity. This makes conventional automated testing, which often ideally requires test probe access to electronic circuitry within the enclosure of the finished product, virtually impossible.

Devices that conform to first, second and third generation mobile phone standards should incorporate a user-removable SIM or USIM card. This card is relatively large (around 15mm x 25mm x 1.2mm), and when inserted into a mobile phone, generally locates in/on to a flat surface of similar size and is held there by a variety of low cost methods.

Low cost, high volume designs (e.g., for consumer communication devices) utilise self-contained SIM card holders that mount on the electronic printed circuit board (PCB) of the device, or use a device surface plus features of the device enclosure to hold the (U)SIM card with minimal cost. In each approach, the (U)SIM card is physically separated from the electronic printed circuit board by a protective uniform insulating surface.

However, this approach has the disadvantage(s) that such known (U)SIM holder designs obscure portions of the printed circuit board on which they are mounted, denying test access to large areas of the PCB.

US-A5,823,828 discloses a mechanism to access SIM connector pins through a top cover of a SIM holder to facilitate testing of the connector pins.

A need therefore exists for a holder for an electronic module and method therefor wherein the abovementioned disadvantage(s) may be alleviated.

### Statement of Invention

In accordance with a first aspect of the present invention there is provided a holder for an electronic module as claimed in claim 1.

In accordance with a second aspect of the present invention there is provided a method of assembling a holder for an electronic module as claimed in claim 9.

Briefly stated, in a preferred embodiment, the present invention provides a (U)SIM card holder that is modified with a number of drilled holes that allow conventional test probe access for conventional probe test equipment to access standard surface mount test probe pads on a PCB.

Whilst the invention relates to all self-contained (U)SIM card holders (lidded or un-lidded), it is equally applicable to (U)SIM card holders that use a device PCB surface plus features of the device enclosure to hold the (U)SIM card.

Preferably, although not necessary in all device designs, metal plating of the surface in which the (U)SIM holder holes are drilled, is provided, as this is a desirable extra feature that makes the invention applicable to a wider range of devices.

### Brief Description of the Drawing(s)

One holder for (U)SIM cards and method therefor incorporating the present invention will now be described, by way of example only, with reference to the accompanying drawing(s), in which:
FIG. 1 shows a perspective view of a (U)SIM card holder for consumer communications devices;
FIG. 2 shows a perspective view of the holder of FIG. 1 mounted on a printed circuit board of a portable wireless modem and undergoing testing; and
FIG. 3 shows a perspective view of the (U)SIM card holder of FIG. 1 mounted on the printed circuit board and with a (U)SIM card mounted inserted in the holder after completion of testing as in FIG. 2.

### Description of Preferred Embodiment(s)

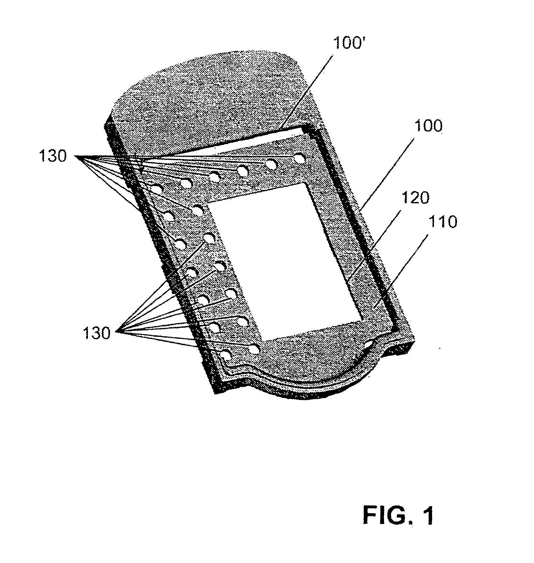

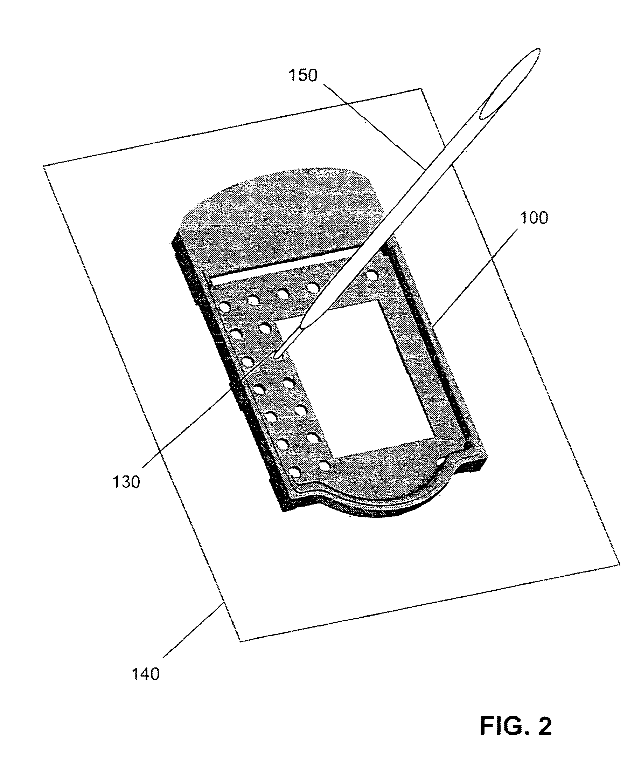

Referring firstly to FIG. 1 and FIG. 2, a (U)SIM card holder 100 for a wireless communication equipment portable modem is made of moulded plastic material in the general form of a frame or tray defining a shallow recess 110 for insertion of a (U)SIM card (described below). The holder 100 has a rectangular aperture 120 therethrough for allowing the inserted (U)SIM to make contact with a printed circuit board (PCB) 140, using a standard sprung connector (not shown), described below, on which the holder is to be mounted. The holder 100 also has eighteen 1.0mm diameter circular drilled/moulded holes 130 in the bottom plastic (U)SIM holder surface. At one side of the recess 110, the card 100 has a through slot 100'.

The holes 130 align with eighteen surface mount test pads (not shown), located on the PCB 140 on which the tray 100 is mounted, that are the standard minimum 0.8mm in diameter and are located on the standard minimum 2.14mm test probe pitch.

It will be understood that FIG. 1 depicts a "lowest cost of ownership" example, and that the invention more generally is not dependent on any standard test probe diameter, test fixture probe pitch, PCB test pad diameter or number of holes drilled.

A standard test fixture may be populated with eighteen standard test probe pins (one of which, 150, is shown) that align with the holes in the (U)SIM tray 100, using locating features (not shown) elsewhere on the device enclosure. When activated, a standard test fixture generally pushes spring-loaded test probes such as the probe 150 through the holes 130 and onto the pads on the printed circuit board below, enabling access to the electronics of the unit under test from the test equipment.

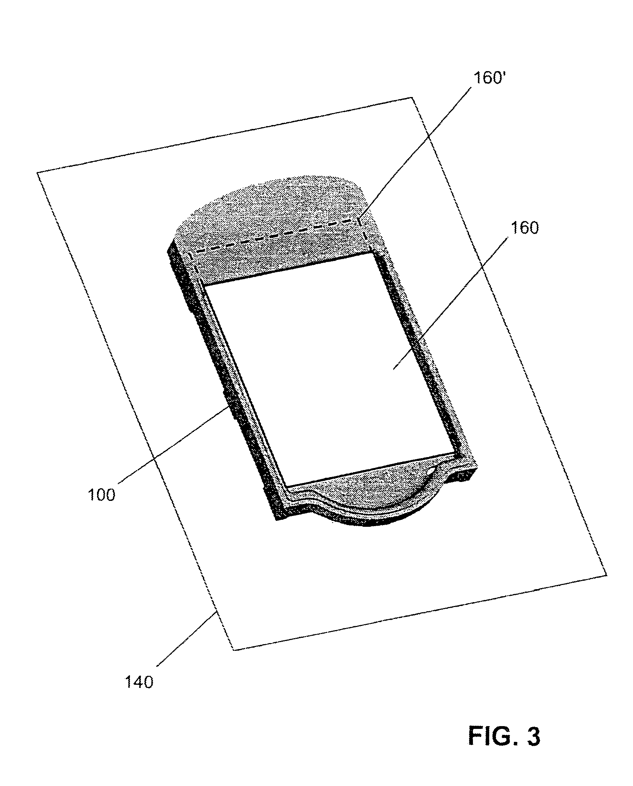

Referring now also to FIG. 3, the holes 130 in the (U)SIM holder 100 are visible at all times until the user inserts the (U)SIM card 160 (by inserting an edge portion 160' - shown in dotted line - of the card through the slot 100'); this action is required to enable standard operation of the device. When inserted, the (U)SIM card 160 covers the holes 130 from sight and protects them and the PCB pads below them from moisture, dirt and any electrostatic discharge (ESD) the device design may allow.

It will be understood that any number of holes/pads/probes may be implemented in the space specifically available in the desired implementation, dependent on the number of electronic test points that need to be accessed. It will also be understood that either surface mount (SMT, as shown FIG. 1), plated through hole (PTH) or interference fit of stand-alone (U)SIM holder designs may be used.

It will further be understood that the (U)SIM holder and method described above allows test access with zero added component cost or degradation of the aesthetics of the device in its final usable form. Location of surface mount test pads on the PCB and the moulding of a modified SIM holder or enclosure surface with this type of hole may be implemented using standard moulding practice and carries no cost penalty.

In the example surface mount implementation of FIG. 1, a masked plating operation is performed on the underside (not visible in the orientation shown in FIG. 1) of the (U)SIM holder to plate metal onto the surface mounting pads. By correctly designing the plating mask, the entire under surface of the SIM holder can be plated to allow shielding for Electro Magnetic Interference (EMI) energy, commonly emitted from electronic components when active, as well as plating the mounting pads.

By designing a plated (U)SIM holder in this way, or adding a plated (U)SIM location surface (used with features of the device enclosure to hold the (U)SIM card, i.e., plating the legs), and connecting the plated area to the relevant ground of the modem device, electrostatic discharge (ESD) protection may be afforded (in conjunction with device enclosure design for ESD) for each pad accessible through the holes in the (U)SIM holder at zero cost. This is possible as ESD energy may travel through the low impedance metal plated area to ground, in preference to travelling through any SMT test pad to ground. It will be appreciated that since it will typically be necessary to plate multiple surface mount feet (not shown) on the underside of the holder 160, by creating the appropropriate sort of plating mask one can plate the entire bottom surface at no significant increase in cost or processing time.

By designing the metal plating mask to create a minimal clearance between the (U)SIM holder hole edge to the plating area, short-circuit of the test probe pins through the metal plating area is avoided.

By designing the metal plating mask to connect any or all surface mount pads to the underside (or any or all other surfaces) of the (U)SIM holder, desirable mechanical contact can be achieved with any EMI-shielding surface designed into the device enclosure (not shown).

It will be understood that the holder for an electronic module and method therefor described above provides the advantage of simple and effective PCB testing before (U)SIM insertion, which may be used with standard fixtures, at no additional cost. It will also be appreciated that effective PCB testing after (U)SIM card insertion in a fully assembled device is also facilitated since the testing can be conducted by probing directly through the holder 100 upon removal of the card 160.

## Claims

1. A holder (100) for an electronic module for connection to a printed circuit board in an electronic equipment, the holder being arranged to receive the electronic module and having a portion provided with at least one hole (120) therethrough,
wherein the holder is **characterised in that**:
at least one hole (120) is arranged to provide access through the holder (100) to the printed circuit board (140) for testing; and
the holder (100) is further provided with a plating mask layer on a surface for positioning adjacent the printed circuit board (140).

2. The holder of claim 1 wherein the at least one hole (120) is arranged to be covered by the electronic module when positioned in the holder (100).

3. The holder (100) of claim 1 or 2 wherein the holder is provided with a plurality of holes (120) therethrough.

4. The holder (100) of claim 1, 2 or 3 wherein the holder is arranged to be mounted on the printed circuit board (140) by one of A-B:
A surface mount technology,
B plated through hole technology.

5. The holder (100) of any preceding claim wherein the electronic module comprises a subscriber identification module (160).

6. The holder (100) of any preceding claim wherein the electronic equipment comprises wireless communication equipment.

7. The holder (100) of claim 6 wherein the wireless communication equipment comprises a portable modem.

8. The holder (100) of any preceding claim wherein the holder is of moulded plastics material.

9. A method of assembling a holder (100) for an electronic module on a printed circuit board (140) of an electronic equipment, the method comprising:
providing a printed circuit board (140);
the method **characterised by**:
providing a holder (100) for the electronic module for connection to the printed circuit board (140), the holder (100) being arranged to receive the electronic module and having a portion provided with at least one hole (120) to provide access through the holder (100) to the printed circuit board (140) for testing purposes,
providing the holder (100) with a plating mask layer on a surface for positioning adjacent the printed circuit board (140); and
mounting the holder on the printed circuit board (140).

10. The method of claim 9 further comprising inserting the electronic module in the holder (100) such that the at least one hole (120) is covered by the electronic module.

11. The method of claim 9 or 10 wherein the holder (100) is provided with a plurality of holes (120) therethrough.

12. The method of claim 9, 10 or 11 wherein the step of mounting comprises mounting the electronic module on the printed circuit board (140) by one of A-B:
A surface mount technology,
B plated through hole technology.

13. The method of any one of claims 9 to 12 wherein the electronic module comprises a subscriber identification module (160).

14. The method of any one of claims 9 to 13 wherein the electronic equipment comprises wireless communication equipment.

15. The method of claim 14 wherein the wireless communication equipment comprises a portable modem.

16. The method of any one of preceding claims 9 to 15 wherein the holder is moulded of plastics material.

17. An electronic circuit having mounted thereon the holder of any one of claims 1-8.

## Patentansprüche

1. Halter (100) für ein elektronisches Modul zur Verbindung mit einer gedruckten Leiterplatte in einer elektronischen Ausrüstung, wobei der Halter dazu angeordnet ist, das elektronische Modul aufzunehmen, und einen Teil aufweist, der mit zumindest einem Loch (120) dorthindurch versehen ist,
wobei der Halter **dadurch gekennzeichnet ist, dass**:
zumindest ein Loch (120) dazu angeordnet ist, zum Testen einen Zugang durch den Halter (100) zur gedruckten Leiterplatte (140) bereitzustellen; und
der Halter (100) ferner mit einer Metallisierungsmaskenschicht an einer Oberfläche zum Positionieren benachbart der gedruckten Leiterplatte (140) versehen ist.

2. Halter nach Anspruch 1, bei dem das zumindest eine Loch (120) so angeordnet ist, dass es durch das elektronische Modul bedeckt ist, wenn es im Halter (100) positioniert ist.

3. Halter (100) nach Anspruch 1 oder 2, bei dem der Halter mit einer Vielzahl von Löchern (120) dorthindurch versehen ist.

4. Halter (100) nach Anspruch 1, 2 oder 3, bei dem der Halter dazu angeordnet ist an der gedruckten Leiterplatte (140) durch A oder B montiert zu werden:
A Oberflächenmontagetechnologie
B Durchmetallisierungs-Technologie

5. Halter (100) nach einem der vorhergehenden Ansprüche, bei dem das elektronische Modul ein Teilnehmeridentifikationsmodul (160) aufweist.

6. Halter (100) nach einem der vorhergehenden Ansprüche, bei dem die elektronische Ausrüstung eine Ausrüstung zur drahtlosen Kommunikation aufweist.

7. Halter (100) nach Anspruch 6, bei dem die Ausrüstung zur drahtlosen Kommunikation ein tragbares Modem aufweist.

8. Halter (100) nach einem der vorhergehenden Ansprüche, bei dem der Halter aus einem Spritzgusskunststoffmaterial besteht.

9. Verfahren zum Einbauen eines Halters (100) für ein elektronisches Modul an einer gedruckten Leiterplatte (140) einer elektronischen Ausrüstung, wobei das Verfahren aufweist:
Bereitstellen einer gedruckten Leiterplatte (140);
wobei das Verfahren **gekennzeichnet ist durch**:
Bereitstellen eines Halters (100) für das elektronische Modul zur Verbindung mit der gedruckten Leiterplatte (140), wobei der Halter (100) dazu angeordnet ist, das elektronische Modul aufzunehmen, und einen Teil aufweist, der mit zumindest einem Loch (120) versehen ist, um für Testzwecke einen Zugang **durch** den Halter (100) zur gedruckten Leiterplatte (140) bereitzustellen,
Versehen des Halters (100) mit einer Metallisierungsmaskenschicht an einer Oberfläche zum Positionieren benachbart der gedruckten Leiterplatte (140); und
Montieren des Halters auf der gedruckten Leiterplatte (140).

10. Verfahren nach Anspruch 9, ferner aufweisend ein Einsetzen des elektronischen Moduls in den Halter (100), sodass das zumindest eine Loch (120) durch das elektronische Modul abgedeckt wird.

11. Verfahren nach Anspruch 9 oder 10, bei dem der Halter (100) mit einer Vielzahl von Löchern (120) dorthindurch versehen ist.

12. Verfahren nach Anspruch 9,10 oder 11, bei dem der Schritt des Montierens ein Montieren des elektronischen Moduls an der gedruckten Leiterplatte (140) durch A oder B aufweist:
A Oberflächenmontagetechnologie
B Durchmetallisierungs-Technologie

13. Verfahren nach einem der Ansprüche 9 bis 12, bei dem das elektronische Modul ein Teilnehmeridentifikationsmodul (160) aufweist.

14. Verfahren nach einem der Ansprüche 9 bis 13, bei dem die elektronische Ausrüstung eine Ausrüstung zur drahtlosen Kommunikation aufweist.

15. Verfahren nach Anspruch 14, bei dem die Ausrüstung zur drahtlosen Kommunikation ein tragbares Modem aufweist.

16. Verfahren nach einem der vorhergehenden Ansprüche 9 bis 15, bei dem der Halter aus einem Kunststoffmaterial spritzgegossen wird.

17. Elektronische Schaltung mit daran montiertem Halter nach einem der Ansprüche 1 bis 8.

## Revendications

1. Support (100) pour un module électronique permettant une connexion à une carte de circuit imprimé d'un équipement électronique, le support étant agencé pour recevoir le module électronique et ayant une partie dotée d'au moins un trou (120),
dans lequel le support est **caractérisé en ce que** :
au moins un trou (120) est agencé pour fournir un accès à travers le support (100) à la carte de circuit imprimé (140) en vue d'effectuer un essai ; et
le support (100) est en outre doté d'une couche de masque de métallisation sur une surface pouvant être positionnée adjacente à la carte de circuit imprimé (140).

2. Support selon la revendication 1, dans lequel l'au moins un trou (120) est ménagé pour être recouvert par le module électronique lorsqu'il est placé dans le support (100).

3. Support (100) selon la revendication 1 ou 2, dans lequel le support est doté d'une pluralité de trous (120).

4. Support (100) selon la revendication 1, 2 ou 3, dans lequel le support est agencé pour être monté sur la carte de circuit imprimé (140) par l'une des techniques A-B suivantes :
A technique du montage en surface,
B technique du trou traversant métallisé.

5. Support (100) selon l'une quelconque des revendications précédentes, dans lequel le module électronique comprend un module d'identification de l'abonné (160).

6. Support (100) selon l'une quelconque des revendications précédentes, dans lequel l'équipement électronique comprend un équipement de communication sans fil.

7. Support (100) selon la revendication 6, dans lequel l'équipement de communication sans fil comprend un modem portable.

8. Support (100) selon l'une quelconque des revendications précédentes, dans lequel le support est composé d'un matériau en plastique moulé.

9. Procédé permettant d'assembler un support (100) pour un module électronique sur une carte de circuit imprimé (140) d'un équipement électronique, le procédé comprenant l'étape consistant à :
fournir une carte de circuit imprimé (140) ;
le procédé étant **caractérisé par** les étapes consistant à :
fournir un support (100) pour le module électronique afin de le connecter à la carte de circuit imprimé (140), le support (100) étant agencé de manière à recevoir le module électronique et ayant une partie dotée d'au moins un trou (120) pour permettre un accès à travers le support (100) à la carte de circuit imprimé (140) en vue d'effectuer un essai,
doter le support (100) d'une couche de masque de métallisation sur une surface pouvant être positionnée adjacente à la carte de circuit imprimé (140) ; et
monter le support sur la carte de circuit imprimé (140).

10. Procédé selon la revendication 9, comprenant en outre l'insertion du module électronique dans le support (100) de telle sorte que l'au moins un trou (120) est recouvert par le module électronique.

11. Procédé selon la revendication 9 ou 10, dans lequel le support (100) est doté d'une pluralité de trous (120).

12. Procédé selon la revendication 9, 10 ou 11, dans lequel l'étape de montage comprend le montage du module électronique sur la carte de circuit imprimé (140) par l'une des techniques A-B suivantes :
A technique du montage en surface,
B technique du trou traversant métallisé.

13. Procédé selon l'une quelconque des revendications 9 à 12, dans lequel le module électronique comprend un module d'identification de l'abonné (160).

14. Procédé selon l'une quelconque des revendications 9 à 13, dans lequel l'équipement électronique comprend un équipement de communication sans fil.

15. Procédé selon la revendication 14, dans lequel l'équipement de communication sans fil comprend un modem portable.

16. Procédé selon l'une quelconque des revendications précédentes 9 à 15, dans lequel le support est moulé dans un matériau en plastique.

17. Circuit électronique sur lequel est monté le support selon l'une quelconque des revendications 1 à 8.
